Europäisches Patentamt

European Patent Office

Office européen des brevets

(19)

(11) Publication number : **0 619 496 A2**

(12) # EUROPEAN PATENT APPLICATION

(21) Application number : **94301947.1**

(22) Date of filing : **18.03.94**

(51) Int. Cl.⁵ : **G01R 33/032, G01R 15/07**

(30) Priority : **26.03.93 GB 9306404**

(43) Date of publication of application :
**12.10.94 Bulletin 94/41**

(84) Designated Contracting States :
**CH DE FR GB LI SE**

(71) Applicant : **LUCAS INDUSTRIES PUBLIC LIMITED COMPANY**
**Brueton House, New Road**
**Solihull, West Midlands B91 3TX (GB)**

(72) Inventor : **Jones, Roger Edward**
**1, Finchers Corner,**
**Cradley**
**Malvern, Worcestershire WR13 5LP (GB)**
Inventor : **Miller, Robert William**
**15, Swallow Close**
**St. Peter's Gardens, Worcester WR5 3HD (GB)**
Inventor : **Taylor, Brian Keith**
**2, The Firs,**
**Bosbury**
**Ledbury, Herefordshire HR8 1PS (GB)**

(74) Representative : **Robinson, John Stuart et al**
**MARKS & CLERK,**
**Alpha Tower,**
**Suffolk Street Queensway**
**Birmingham, B1 1TT (GB)**

(54) **Magnetic field sensor.**

(57)    A magnetic field sensor is provided in which plane polarised light at first and second wavelengths is admitted into a block (2) of material exhibiting the Faraday effect. The light undergoes rotation of its plane of polarisation in the presence of a magnetic field. The angle of rotation of the plane of polarisation is proportional to the strength of the magnetic field, and is a function of wavelength of the light. The light emerging from the block (2) is analysed to determine the amount of rotation experienced by each wavelength. Inclusion of an output polariser (24) results in a sensor in which the light leaving the sensor is colour encoded as a function of magnetic field.

FIG.1a.

EP 0 619 496 A2

The present invention relates to a magnetic field sensor.

Some types of known magnetic field sensors employ electrical sensors to measure magnetic fields. In environments where high voltages and/or large electric field gradients are encountered, such as in power distribution systems, it may be desirable to use a sensor that is not connected via electrically conductive means to data processing or recording equipment.

EP-B-0 081 367 discloses a magnetic field sensor where the Faraday effect is used to intensity modulate light passing through a Faraday cell. The light intensity is detected by a photodetector. When the angle between the polariser and the analyser is set at 45°, the output of a photodetector is given by:

$$Vout = 1/2 . K . (1 + \sin 2\theta)$$

where:
K is a constant determined by the intensity of the light and the sensitivity of the photodetector; and
$\theta$ is the angle of rotation of the plane of polarisation.

Thus the output is periodic with changes in magnetic field, since the angle of rotation $\theta$ is proportional to magnetic field. Consequently the sensitivity of such an arrangement falls as the output approaches the maxima and minima of the response. In order to achieve substantially linear operation, the variation in $\theta$ must be kept small.

SU 757 990 describes a device in which light from a laser is directed around a Faraday cell encircling an electrical conductor. The amount of rotation of the plane of polarisation is measured to determine the current through the electrical conductor.

NL 8700 697 A describes a similar arrangement in which a substantially rectangular Faraday cell encircles an electrical conductor. Light enters and exits the cell at a single corner to minimise the effects of stray magnetic fields.

According to a first aspect of the present invention there is provided a magnetic field sensor, comprising a source of plane polarised radiation having at least first and second wavelengths; an optical element of a material exhibiting the Faraday effect, the optical element having an input surface and an output surface; and an analyser for measuring an amount by which the plane of polarisation of the first wavelength is rotated and for measuring an amount by which the plane of polarisation of the second wavelength is rotated, the radiation being arranged to enter the optical element perpendicular to the input surface and to exit the optical element at the output surface.

The amount of rotation experienced by the radiation is a function of magnetic field strength, optical path length within the optical element, and a Verdet constant. The Verdet constant changes with different materials and is also wavelength dependent. The Verdet constant is, at least to a first approximation, inversely proportional to $\lambda^2$ where $\lambda$ represents wavelength.

Preferably the optical element comprises a block of transparent material having first and second surfaces arranged such that the radiation undergoes multiple reflections between the first and second surfaces. Advantageously the first and second surfaces are coated to form mirrors.

The optical element may be formed of a glass.

Preferably the radiation is light. Light in this context includes infra-red radiation, visible radiation and ultra-violet radiation. Preferably the source of radiation is a polychromatic light source. Advantageously the light source has a broad spectral distribution. The spectral distribution may be substantially free of missing wavelengths. The light may be substantially white. The light may be polarised at the radiation source. Preferably the optical element may have an input plane polariser adjacent, or at, the input surface.

Preferably the light exiting from the output surface is passed through an output plane polariser to select light having a determined plane of polarisation. Advantageously the output surface is arranged such that the light exits the optical element perpendicular to the output surface.

Advantageously the direction of polarisation of the output plane polariser is set at an angle of substantially 45 degrees with respect to the polarisation of the light entering the optical element.

Advantageously the output plane polariser is positioned adjacent, or at, the output surface.

The output plane polariser may be formed on the output surface. Similarly the input plane polariser may be formed on the input surface.

Preferably the analyser is arranged to measure the spectral intensity distribution of the polarised light selected by the output plane polariser. The analyser may be used to form an "average" of the spectral intensity distribution within a predetermined range of wavelengths. The "average" is such that an equivalent wavelength or "colour" can be defined to replace the spectrum, and that the "colour" can be plotted on to a mapping diagram which is the generalised form of a special diagram known as a chromaticity diagram. "Colour" in this context is used in an extended sense to ascribe the concept of colour to light that falls outside the range of human colour vision.

The relative intensities of the first and second wavelengths vary as a function of magnetic field by virtue of the Verdet constant being wavelength dependent; thus the angle each of the polarised wavelengths makes with the axis of the output polariser varies with magnetic field since different wavelengths undergo different amounts of rotation. When the source of radiation is a broadband light source, the spectral distribution of light incident on the analyser varies with magnetic field. The change in spectral distribution, when observed by the human eye and when the first and second wavelengths fall within the visible region of the electromagnetic spectrum, would be seen as a change in colour with changing magnetic field.

If the light lay solely within the visible part of the electromagnetic spectrum, the analyser would be sensitive to the colour of the light passing through the output plane polariser.

Preferably the analyser comprises at least first and second photodetectors having first and second spectral responses, respectively. Advantageously the analyser further comprises a third photodetector having a third spectral response.

Processing means may be provided for indicating field strength as a function of a quotient of outputs of the first and second photodetectors. Preferably, when the third photodetector is provided, the processing means is arranged to provide first and second quotients wherein the denominators include contributions from the first, second and third photodetectors and the first and second numerators are proportional to the outputs of the first and second photodetectors, respectively.

The spectral responses of the photodetectors may be quite broad and overlap.

A description of a suitable analyser is to be found in European Patent Application No.EP 0 224 994 A3.

According to a second aspect of the present invention there is provided a current sensor comprising a magnetic field sensor according to the first aspect of the present invention for measuring the magnetic field adjacent a current carrying conductor.

Preferably the magnetic field sensor is positioned within a magnetic circuit comprising a magnetic core.

The present invention will further be described, by way of example, with reference to the accompanying drawings, in which:

Figure 1a is a schematic diagram of a current monitor using a magnetic field sensor constituting an embodiment of the present invention;

Figure 1b is a schematic diagram showing the sensor head of the monitor shown in Figure 1a within a magnetic circuit for concentrating flux at the sensor head;

Figure 2 is an example of the results of a test measurement showing how dominant wavelength changes with magnetic field;

Figure 3 is an example of the spectral response characteristics of photodetectors suitable for use in an analyser; and

Figure 4 is a mapping diagram for the sensor responses shown in Figure 3.

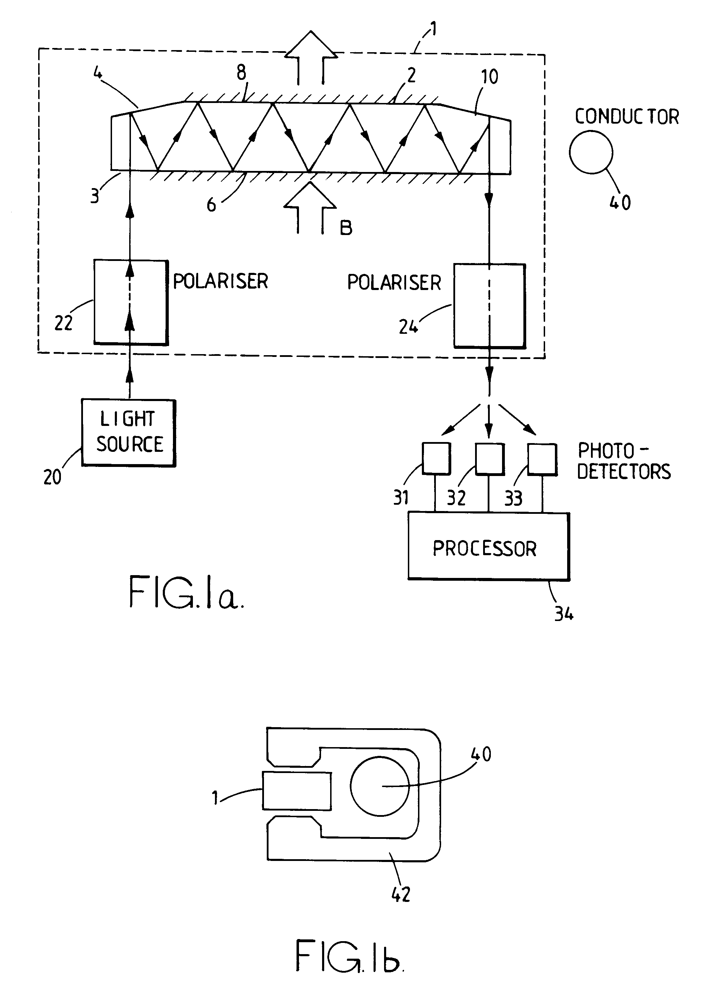

The magnetic field sensor of Figure 1 has a sensor head, indicated generally as 1, containing a Faraday cell 2. The Faraday cell 2 consists of a block of transparent material which exhibits the Faraday effect. A suitable material is SF 57 glass, available from SCHOTT. SF 57 glass has negligible intrinsic bi-refringence. Thus, in the absence of a magnetic field, the plane polarised light undergoes little or no rotation. The Faraday effect in SF 57 glass is almost unaffected by temperature changes, i.e. Verdet's constant is substantially constant with respect to temperature. A large range of materials exhibit the Faraday effect and many are suitable for use in place of SF 57 glass.

The Faraday cell 2 is elongate. Light is admitted at a first end of the cell 2 via a first surface 3 and is reflected from a first reflecting surface 4 towards a second reflecting surface 6, which lies within the plane of the first surface 3. The light is then directed along a folded optical path which includes multiple reflections between the second reflecting surface 6 and a third reflecting surface 8. The second and third reflecting surfaces are shown as being mirrored, although mirroring or total internal reflection may be used. The length of the path is increased by virtue of the multiple reflections, thereby simulating a Faraday cell of greater length than the physical length of the Faraday cell 2. The light is reflected from a fourth reflecting surface 10 before exiting the Faraday cell 2 via the first surface 3.

The first and fourth reflecting surfaces 4 and 10 are inclined with respect to the planes of the second and third reflecting surfaces 6 and 8. The inclination is chosen such that light can enter and exit the cell 2 perpendicular to the plane of the first surface 3 and then be directed towards, and received from, the folded optical path. Refraction of the light is avoided by arranging for the light to enter and exit the cell 2 normal to the first surface 3.

The light entering the Faraday cell 2 is polychromatic light plane polarised along a first axis. The light is provided by a broad band light source 20 which may include a polariser. Alternatively an input polariser 22 may be provided within the sensor head 1 adjacent the Faraday cell 2, as illustrated, so as to plane polarise the light entering the cell along the first axis. As a further alternative the input polariser may be formed on the first surface 3 of the Faraday cell 2.

Light emerging from the Faraday cell 2 is passed through an output polariser 24 so as to select light polarised along a second axis for transmission towards photodetectors 31, 32 and 33. The second axis is inclined at an angle of 45° with respect to the first axis. The output polariser may also be formed on the surface of the Faraday cell 2. Outputs of the photodetectors 31 to 33 are connected to a processor which analyses the outputs to determine the strength of a magnetic field B at the sensor head 1. The magnetic field B, the flux direction of which is represented by the arrows adjacent the Faraday cell 2, may be due to current flowing in an adjacent conductor 40. For instance, the sensor head 1 may be located in a gap of a magnetic circuit 42 which encircles the conductor 40 carrying the current to be measured, as shown in Figure 1b.

The polychromatic light entering the Faraday cell 2 is plane polarised along the first axis. As the light passes along the Faraday cell, the plane of polarisation of the light is rotated.

The angle of rotation $\theta(\lambda)$ is given by:

$$\theta(\lambda) = B\,L\,V(\lambda) \quad (1)$$

where:

    B is the magnetic field strength in Tesla T;

    L is the optical path length in metres m; and

    $V(\lambda)$ is Verdet's constant (rad/m/T).

Verdet's constant is dependent on wavelength. Thus for a given magnetic field and path length, different wavelengths of light undergo different amounts of rotation. For polychromatic light, the slight differences in the spectral intensity distribution can easily be detected, for example by colour change in the transmitted light, where the term "colour" has its normal meaning for light falling within the region of human colour vision and refers to a similar mapping where at least one wavelength falls outside the normal visible region, e.g. infrared or ultraviolet radiation.

The changes in spectral distribution can be detected more easily than the small changes in polarization of the light of a given wavelength. Thus the output of the Faraday cell is wavelength encoded rather than intensity encoded.

The magnetic field strength at the sensor head may be increased by the use of a magnetic core, for example of magnetically soft iron, to concentrate the magnetic flux into the region of the Faraday cell 2.

For SF 57 glass, Verdet's constant is approximately 40 for light having a wavelength of 500 nm, but Verdet's constant is only approximately 20 for light having a wavelength of 700 nm.

For a Faraday cell of SF 57 glass having an optical path length of 0.1 metres, a magnetic field of 0.2T would give rise to a 45° rotation for 500 nm light and approximately 23° for 700 nm light. Thus, with the axis of polarisation of the second polariser inclined at an angle of 45° with respect to the polarisation of light entering the Faraday cell 2, the 500 nm light is extinguished whereas the intensity of the 700 nm light is reduced by half.

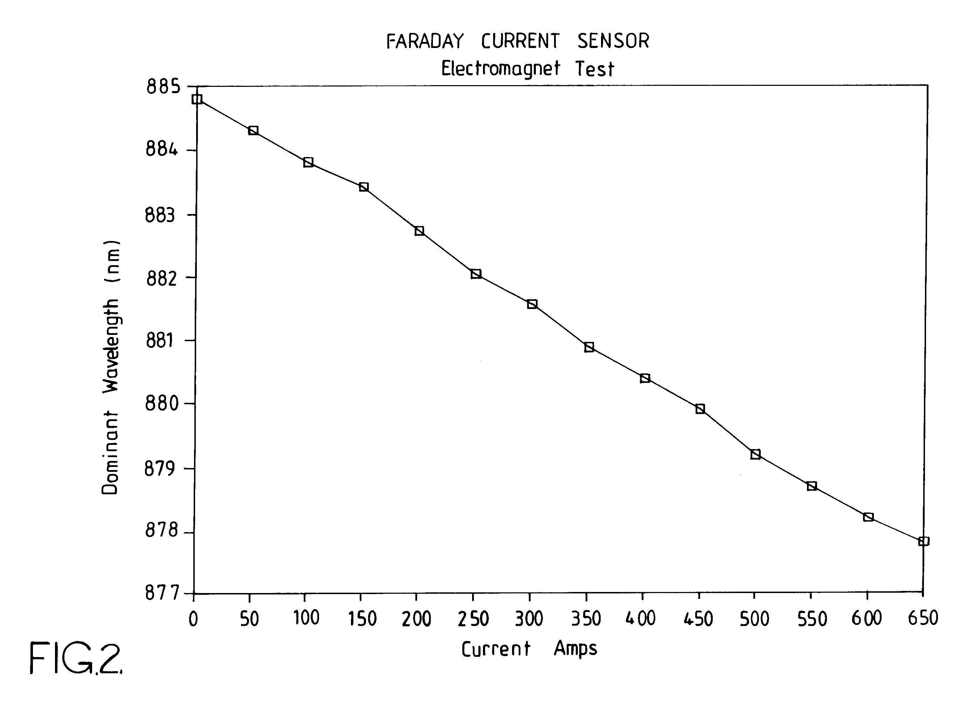

Figure 2 shows the output from a test device showing the shift in dominant wavelength with current through a conductor adjacent the sensor head.

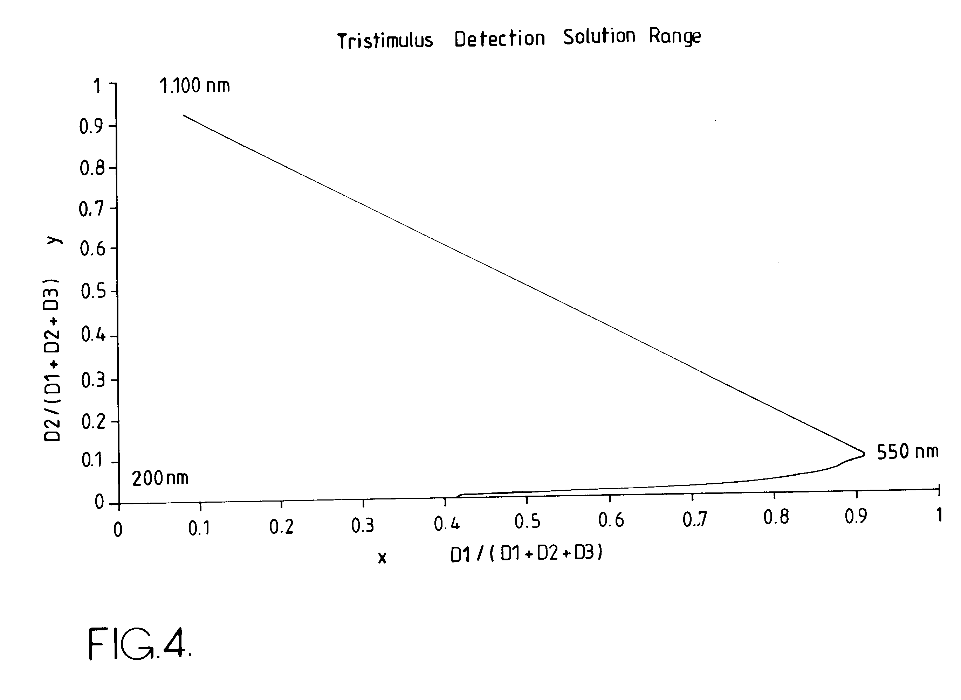

The dominant wavelength can be detected by a detector and mapped onto a mapping diagram. The mapping diagram shown in Figure 4 allows an intensity independent assessment of wavelength. The mapping diagram is a general case of the more specific chromaticity diagram which allows an intensity independent assessment of colour for light falling within the range of human colour vision.

The coordinates on the mapping or chromaticity diagram can be calculated, for a measurement system utilising three sensors, from the equations:

$$x = X / (X + Y + Z) \quad (2)$$
$$y = Y / (X + Y + Z) \quad (3)$$

where:

$$X = \int \lambda\, P(\lambda)\, \overline{x}(\lambda)\, d\lambda \quad (4)$$
$$Y = \int \lambda\, P(\lambda)\, \overline{y}(\lambda)\, d\lambda \quad (5)$$
$$Z = \int \lambda\, P(\lambda)\, \overline{z}(\lambda)\, d\lambda \quad (6)$$

$\lambda$ represents wavelength;

$P(\lambda)$ is the power density as a function of wavelength; and

$\overline{x}(\lambda)$, $\overline{y}(\lambda)$, and $\overline{z}(\lambda)$ are matching functions dependent upon the response of the photodetectors, as described in EP 0 224 994.

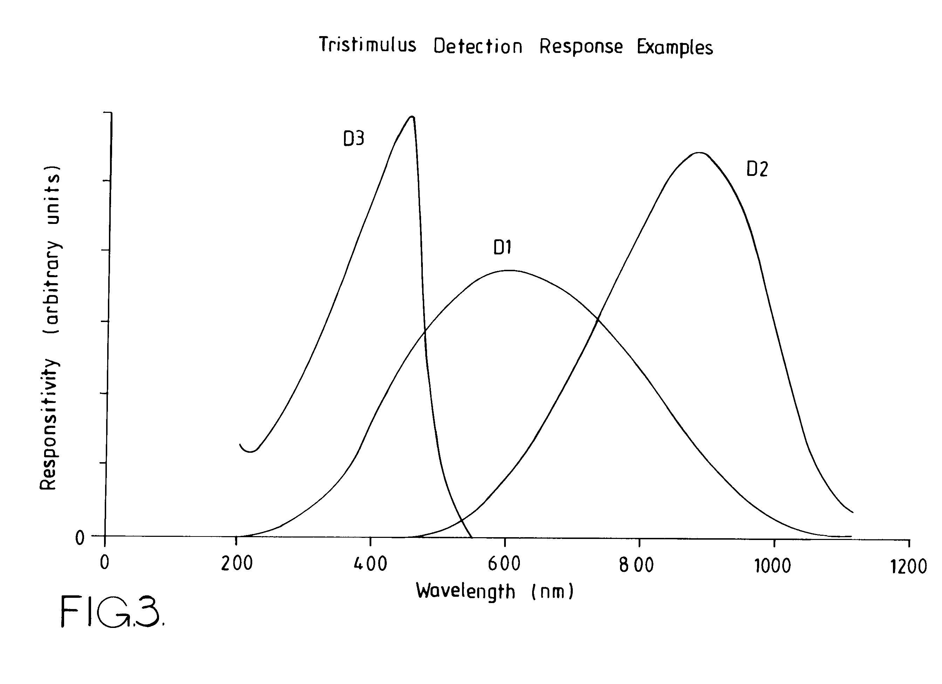

The photodetectors 31, 32 and 33 have outputs representing X, Y and Z, respectively, connected to first, second and third inputs of a processor 34. The first, second and third photodetectors may have the responses indicated by D1, D2 and D3, respectively, in Figure 3. The processor may apply a pre-scaling to the outputs of each photodetector to compensate for differences in sensitivity. The processor forms the value of the output of the first sensor divided by the sum of the outputs of all three sensors to form a value x for mapping along the ordinate of the mapping diagram, and the value of the output of the second sensor divided by the sum of the outputs of all three sensors to form a value y for mapping along the abscissa of the mapping diagram. The processor may also be arranged to provide a trigonometric output representing an angle from a predefined reference point on the mapping diagram to the mapped point represented by x and y. The position on the mapping diagram can then be related to magnetic field strength by suitable calibration.

The light source 20, the photodetectors 31 to 33, and the processor 34 may be physically remote from the sensor head 1. Light may be guided to and from the sensor head 1 via optical fibres (not shown). Such an arrangement allows electronic circuitry to be located remotely from the sensor head, thereby reducing the possibility of electrical noise being introduced by varying magnetic fields and electric field gradients.

It is thus possible to provide a magnetic field sensor where relatively small changes in polarisation between different wavelengths of light are detected and mapped onto a mapping diagram to provide a determination of magnetic field strength. The mapping operation is substantially independent of light intensity, thereby avoiding the problems of intensity based systems where changes in illuminator intensity may falsely be detected as changes in magnetic field or current through a conductor.

**Claims**

1. A magnetic field sensor, comprising a source (20, 22) of plane polarised radiation, and an optical element (2) of a material exhibiting the Faraday effect, the optical element (2) having an input surface (3) and an output surface (3), the radiation being arranged to enter the optical element perpendicular to the input surface (3) and to exit the optical element at the output surface (3), characterised by the source (20, 22) being arranged to provide radiation having at least first and second wavelengths and an analyser (24, 31-34) for measuring an amount by which the plane of polarisation of the first wavelength is rotated and for measuring an amount by which the plane of polarisation of the second wavelength is rotated.

2. A magnetic field sensor as claimed in Claim 1, characterised by further comprising a first plane polariser (24) arranged to select radiation exiting from the output surface and having a determined plane of polarisation.

3. A magnetic field sensor as claimed in Claim 2, characterised in that the direction of polarisation of the first plane polariser (24) is set at an angle of substantially 45 degrees with respect to the polarisation of the radiation entering the optical element (2).

4. A magnetic field sensor as claimed in Claim 2 or 3, characterised in that the analyser (24, 31-34) is arranged to measure the spectral intensity distribution of the polarised radiation selected by the first plane polariser (24).

5. A magnetic field sensor as claimed in Claim 4 characterised in that the analyser (24, 31-34) is arranged to form an average of the spectral intensity distribution within a predetermined range of wavelengths.

6. A magnetic field sensor as claimed in any one of the preceding claims, characterised in that the optical element (2) comprises a block (2) of transparent material having first and second surfaces (6, 8) arranged such that the radiation undergoes multiple reflections between the first and second surfaces (6, 8).

7. A magnetic field sensor as claimed in any one of the preceding claims, characterised in that the source of plane polarised radiation comprises an input plane polariser adjacent or at the input surface (3).

8. A magnetic field sensor as claimed in any one of the preceding claims, characterised in that the source (20, 22) of plane polarised radiation comprises a polychromatic light source.

9. A magnetic field sensor as claimed in any one of the preceding claims, characterised in that the analyser comprises at least first and second photodetectors (31, 32) having first and second spectral responses, respectively.

10. A magnetic field sensor as claimed in Claim 9, characterised by processing means (34) for indicating magnetic field strength as a function of a quotient of outputs of the first and second photodetectors (31, 32).

11. A magnetic field sensor as claimed in Claim 9, characterised in that the analyser further comprises a third photodetector (33) having a third spectral response, and processing means (34) arranged to indicate magnetic field strength as first and second quotients, wherein the denominators include contributions from the first, second and third photodetectors (31, 32, 33), and the first and second numerators are proportional to the outputs of the first and second photodetectors (31, 32), respectively.

12. A current sensor, characterised by a magnetic field sensor (1) as claimed in any one of the preceding claims for measuring a magnetic field adjacent a current carrying conductor (40).

13. A current sensor as claimed in Claim 12, characterised in that the magnetic field sensor (1) is positioned within a magnetic circuit comprising a magnetic core (42).

FIG.1a.

FIG.1b.

FARADAY CURRENT SENSOR
Electromagnet Test

FIG.2.

EP 0 619 496 A2

Tristimulus Detection Response Examples

FIG.3.

EP 0 619 496 A2

Tristimulus Detection Solution Range

FIG.4.

EP 0 619 496 A2